# EUROPÄISCHE PATENTSCHRIFT

(11) **EP 3 301 730 B1**
(45) Veröffentlichungstag und Bekanntmachung des Hinweises auf die Patenterteilung: **26.12.2018**
(21) Anmeldenummer: 16191516.0
(22) Anmeldetag: 29.09.2016
(51) Int. Cl.: H02N 2/18, H02N 2/10, H02N 2/04, H01L 41/113, H01L 41/09

(54) **ENERGIEWANDLERVORRICHTUNG**
ENERGY CONVERTER DEVICE
CONVERTISSEUR D'ÉNERGIE

(43) Veröffentlichungstag der Anmeldung: 04.04.2018
(73) Patentinhaber: Airbus Defence and Space GmbH, 82024 Taufkirchen (DE)
(72) Erfinder: Storm, Stefan, 85716 Unterschleißheim (DE)
(74) Vertreter: Isarpatent

(56) Entgegenhaltungen:
- WO-A2-02/071592
- DE-A1-102005 022 355
- DE-A1-102007 028 642
- DE-C1- 19 535 481
- US-A1- 2010 176 690
- US-B1- 6 194 815
- US-B1- 6 376 968

## Beschreibung

Die Erfindung betrifft eine Vorrichtung zur elektromechanischen Energiewandlung zwischen einer Antriebsseite und einer Abtriebsseite der Vorrichtung, mit einem Rotationstrieb, mittels dessen eine rotatorische Bewegung eines Rotationsglieds in eine überlagerte Linear- und Kippbewegung einer Koppel umsetzbar ist, mit deren Bereich eines ersten Endes das Rotationsglied verbindbar oder verbunden ist, und mit wenigstens einer Aktuatorik, welche mit einem Bereich eines zweiten Endes der Koppel verbindbar oder verbunden ist und welche die überlagerte Linear- und Kippbewegung der Koppel antreibt oder durch diese angetrieben ist.

Derartige Energiewandlungsvorrichtungen sind im Prinzip bekannt und werden verbreitet eingesetzt, um Linearbewegungen eines Aktuators in Rotationsbewegungen an einer Welle zu überführen. Dabei werden diese Energiewandlungsvorrichtungen etwa als elektromechanische Stellantriebe eingesetzt, wie beispielsweise in der DE102005022355A1. Solche Stellantriebe weisen jedoch in ihrer Raumforderung eine nicht eben besonders vorteilhafte Geometrie auf, sind hinsichtlich ihrer Kosten aufwändig und haben durch die direkte Schubbelastung der Aktuatoren eine reduzierte Lebensdauer zu gewärtigen.

### Außerdem können solche

Vorrichtungen nicht im Generatorbetrieb verwendet werden.

Weitere Vorrichtungen sind aus US 6 194 515 B1, US 6 376 968 B1, WO 02 / 071592 A1, DE 10 2007 0288642 A1, DE 195 35 481 C1 und US 2010 / 176690 A1 bekannt.

Es besteht daher die Aufgabe, eine verbesserte Energiewandlungsvorrichtung bereit zu stellen, die einen einfachen, kompakten Aufbau aufweist, geringe Kosten in der Herstellung verursacht, zuverlässig im Betrieb ist und eine verlängerte Lebensdauer mitbringt.

Diese Aufgabe wird erfindungsgemäß durch eine Energiewandlungsvorrichtung mit den Merkmalen des Anspruchs 1 gelöst. Die Lösung besteht demnach insbesondere darin, bei einer Energiewandlungsvorrichtung der eingangs genannten Art die Aktuatorik mit zumindest einem Aktuatorelement zu versehen, und eine Deformation an dem zumindest einen Aktuatorelement der Aktuatorik entweder die Energiewandlung verursachen zu lassen oder durch diese die Energiewandlung zu verursachen ist, wobei insbesondere die Aktuatorik wenigstens einen Schub-/Kipp-Aktuator bildet. Die Energiewandlung kann dabei in beide Wandlungsrichtungen mit einem hohen Kopplungsgrad stattfinden.

Im Sinne eines einfachen Aufbaus mit einer reduzierten Anzahl von Einzelteilen kann bei einer Ausführungsform der erfindungsgemäßen Energiewandlervorrichtung der Schub-/Kipp-Aktuator durch einen kombinierten Aktuator gebildet sein, der beide Bewegungen vorteilhaft in einem Aktuator vereint. Es können aber für die Einzelbewegungen auch jeweils getrennte Aktuatoren vorgesehen sein.

Mithin wird beispielsweise als Antriebseinheit die Aktuatorik eingesetzt, um, wie weiter unten noch klarer werden wird, mittels verstärkter Linear- und Kippbewegung eine kreisförmige Bewegung zu erzeugen. Umgekehrt kann aber auch die Rotationsbewegung des Rotationsglieds mit der Koppel zur Energiegewinnung eingesetzt werden. Eine Koppel mit einer Verbindungsstange stellt die mechanische Ankopplung der Aktuatorik zu einem Rotationstrieb her, der beispielsweise mit einem speziell ausgeformten Planetengetriebe oder mit einer Kurbelwelle gebildet sein kann. Dabei wird im Aktuatorbetrieb die erzeugte Bewegung um einen Rotationsmittelpunkt, insbesondere eine kreisförmige Bewegung, am Ende der Verbindungsstange in eine Drehbewegung auf einer Welle überführt. Hierdurch kann folglich auch ein Antrieb definiert werden, bei dem ein entsprechender piezoelektrischer oder magnetostriktiver Energiewandler zum Einsatz kommt, und der eine Drehbewegung wie bei einem Elektromotor erzielt. Vorteilhaft kommt dieser Antrieb ohne Verzahnung aus, durch den Einsatz bspw. von Piezo-Aktoren kann eine Beaufschlagung mit einem Anpressdruck vermieden werden kein aktiver Anpressdruck, die Herstellungskosten sind aufgrund des einfachen Aufbaus reduziert, außerdem kann die Wandlungsvorrichtung auch mit lediglich einem Aktor betrieben werden.

Umgekehrt erzeugt die Drehbewegung wiederum eine Verformung von piezoelektrischen oder magnetostriktiven Elementen, deren Ladungsverschiebung zur Energiegewinnung genutzt werden kann, weswegen in einer zweckmäßigen Weiterbildung der Energiewandlervorrichtung diese wahlweise als Motor oder als Generator betreibbar ist. Im Aktuatorbetrieb werden dabei hohe Spannungen benötigt (bspw. bis zu 200V etwa bei einem Piezo-Stack, oder bis zu 600V bei einem Piezo-Bieger), umgekehrt werden im Generatorbetreib auch hohe Spannungen erzeugt, die in einem Zwischenkreis gespeichert werden können. Die Spannung im lastfreien Generatorbetrieb (verbunden mit einem hohem Ausgangswiderstand, im Sinne einer Leerlaufspannung) ist dabei abhängig von der Verformung, aufgrund des Zwangslaufs erhält man stets eine gleiche Verformung wodurch jeweils eine konstante Spannung erzeugt wird.

Weitere vorteilhafte Merkmale beinhalten die Unteransprüche.

In geeigneter Weise lässt sich die Antriebsbewegung der Aktuatorik, die sich auch mit nur einem Aktuatorelement erzeugen lässt, in eine Drehbewegung an dem Rotationsglied umsetzen, wenn bei einer Ausführung der erfindungsgemäßen Energiewandlungsvorrichtung das Rotationsglied mit wenigstens einem Kurbeltrieb oder wenigstens einem Planetengetriebe ausgebildet ist.

In einer anderen vorteilhaften Ausführungsform der Energiewandlungsvorrichtung kann der wenigstens eine Kurbeltrieb als Rotationsglied eine Kurbelwelle über wenigstens eine Zapfenerweiterung mit dem Bereich des ersten Endes der Koppel verbinden. Bei einer solchen Zapfenerweiterung kann eine Scheibenkurbel in Art einer Exzenterscheibe eine gekröpfte Kurbelwelle ersetzen und weiter auch den Raumbedarf der Wandlungsvorrichtung positiv beeinflussen. Auf diese Art kann eine verzahnungsfreie Kopplung realisiert sein, die mit hoher Zuverlässigkeit arbeitet und einem geringen Verschleiß unterliegt. Insbesondere bei einer Aktuatorik mit einer Übersetzungsmechanik, wie weiter unten beschrieben, sind auch größere Kurbellängen möglich, was den Aufbau der Energiewandlungsvorrichtung weiter vereinfacht. Insbesondere eignen sich derartige Energiewandlungsvorrichtungen auch zur Miniaturisierung und mithin für den Bereich der Nanotechnologie.

Bei einer weiteren vorteilhaften Ausführungsform der Energiewandlungsvorrichtung kann das wenigstens eine Planetengetriebe als Rotationsglied mit wenigstens einem Planetenrad versehen sein, welches mit dem Bereich des ersten Endes des Koppel verbindbar oder verbunden ist, wobei das wenigstens eine Planetenrad mit einem Zentralrad in Eingriff steht. Mit einer solchen Anordnung lassen sich abtriebsseitig sowohl hohe (Übersetzung) als auch niedrige (Untersetzung) Drehzahlen erzeugen.

In bevorzugten Weiterbildungen der Energiewandlungsvorrichtung kann dabei das Zentralrad mit einer Innenverzahnung oder einer Außenverzahnung zu dem wenigstens einen Planetenrad jeweils komplementär verzahnt sein.

Eine zweckmäßige Ausführung der erfindungsgemäßen Energiewandlungsvorrichtung kann mit einer Koppel gebildet sein, die durch eine Art Schubstange oder Treibstange, insbesondere durch ein Pleuel gebildet ist. Mit Blick auf die Aktuatorik bildet dabei das erste Ende des Pleuels quasi ein freies Ende, und das zweite, antriebsseitige Ende bildet ein festes Ende. Üblicherweise ist die nahezu kreisförmige Bewegung des freien nicht mit der Kurbelwelle verbundenen Pleuelendes kleiner als die Kreisbahn der Kurbel. Es wird also aufgrund der Koppelung in Art eines Zwangslaufs eine größere Aktuatorbewegung erzwungen. Dies gilt für eine reduzierte elektrischen Ansteuerspannung der Aktoren bzw. Aktuatorelemente der Aktuatorik oder falls die hierfür benötigte elektrische Ansteuerspannung nicht aufgebracht werden kann. Solange die maximale mechanische Druckbelastung nicht überschritten wird, wirkt sich der Zwangslauf also positiv auf den elektrischen Leistungsbedarf des Gesamtsystems aus. Das Wirkprinzip des Aktuators ist folglich das eines Kraftgenerators, die Aktuatorspannung ist proportional zur Aktuatorkraft, mithin also proportional zum Drehmoment.

Die Aktuatorik arbeitet dabei ähnlich wie gegen eine negative Federsteifigkeit wie bei einem Servo-Effekt, wodurch sich der elektromechanische Kopplungsfaktors etwa einer Piezokeramik als Aktor erhöht, das heißt, es kann mehr elektrische Energie in mechanische Energie umgewandelt werden.

In vorteilhafter Weise kann bei einer weiteren Ausführung der erfindungsgemäßen Energiewandlungsvorrichtung das zumindest eine Aktuator-Element der Aktuatorik als wenigstens ein Piezo-Aktor oder als wenigstens ein magnetostriktiver Aktor eingerichtet sein. Unter einer bevorzugt regelbaren Ansteuerspannung kann der wenigstens eine Piezo-Aktor sich unter dem inversen Piezo-Effekt verformen und hierdurch das betreffende Aktuator-Element, an welchem er angeordnet ist, verformen. Im Generatorbetrieb kommt demgegenüber natürlich der direkte Piezo-Effekt zum Tragen.

Mit wenigstens einem oder auch einer Mehrzahl etwa von Piezo-Aktoren an einem oder mehreren Aktuator-Elementen bildet die Aktuatorik beispielsweise einen Piezo-Motor, der keine elektrische Leistung für ein statisches Moment benötigt und bei dem, wie bereits erwähnt, die Spannung proportional zum Drehmoment ist, anders als beim Elektromotor, wo es die Stromstärke ist.

Weiter treten bei dieser Art von Antrieb keine magnetischen Felder und nahezu keine ohmschen Verluste auf und das Drehmoment ist unabhängig anpassbar. Überdies kann durch die Wahl des Aufbaus der Zustand im spannungslosen Zustand manipuliert, sprich gewählt werden, nämlich als Freilauf oder selbsthemmend. Ist ein Freilauf im spannungslosen Zustand erwünscht (z.B. beim Motor/Generator), sollten die Mittelpunkte der Bewegungsbahnen des zuvor erwähnten freien Pleuelendes und der Kurbel konzentrisch sein. Ist demgegenüber eher eine bevorzugte Winkelposition erwünscht (z.B. beim der Verwendung als Sidestick mit force feedback oder bei einer Klappe mit definierter, spannungsloser Winkelposition, hierbei wird im Unterscheid zu einem Aufbau mit Vollkreisbewegung nur ein definierter Winkelbereich durchfahren), sollten die genannten Mittelpunkte gegeneinander verschoben sein. Gleichzeitig zeichnet sich der betreffende Antrieb durch die Möglichkeit des schnellen Anfahrens bei gutem Gleichlauf und hohem Wirkungsgrad aus. Aufgrund der Möglichkeit zur Positionsbestimmung lässt sich die erfindungsgemäße Energiewandlungsvorrichtung wie ein Servoantrieb einsetzen, bei dem der Motor mit einem oder mehreren Reglern in einem geschlossenen Regelkreis betrieben wird. Im Übrigen lässt sich die Vorrichtung etwa auch zur Winkelmessung verwenden.

Der bereits erwähnte wenigstens eine Piezo-Aktor kann bei einer vorteilhaften Ausführung der Energiewandlungsvorrichtung, die gegebenenfalls eine beeinflussbare Verteilung der Kraftausübung der Piezo-Elemente auf den Piezo-Aktor bzw. das jeweilige Aktuator-Element gestattet, mit mindestens einem Piezo-Element, bevorzugt mit einer Mehrzahl von Piezo-Elementen, vorgesehen sein. Außerdem ist es denkbar, den wenigstens einen Piezo-Aktor mit wenigstens einem Rückstellelement auszubilden, welches bevorzugt durch wiederum wenigstens ein Piezo-Element oder durch zumindest ein Federelement gebildet ist. Hierdurch wird der jeweilige Piezo-Aktor nicht nur aktiv "ausgelenkt", sondern auch bspw. durch weitere Piezo-Elemente gegen die vorige Auslenkung beaufschlagt. Die für die beiden prinzipiell gegensätzlichen Wirkungsrichtungen des jeweiligen Aktuatorelements zuständigen, an einander abgewandten Flächen angeordneten Piezo-Aktoren könnte man entsprechend als Agonist und Antagonist bezeichnen. Eine für die Bewegung oder jeweilige Bewegungsrichtung zweckmäßige Ansteuerung kann mit einer dezidierten Phasenlage der jeweiligen Piezo-Aktoren erreicht werden. Anstatt von Piezo-Aktoren angeordnete Federn stellen demgegenüber nur eine Rückstellkraft zur Verfügung, die überdies mit einem reduzierten Drehmoment einhergeht.

Damit die Piezo-Elemente ihre Verformung in geeigneter Weise an den jeweiligen Piezo-Aktor vermitteln können , kann in bevorzugten Ausführungen der Energiewandlungsvorrichtung der wenigstens eine Piezo-Aktor zum Beispiel nach Art eines Biegebalkens als sogenannter Piezo-Bieger vorgesehen sein, an welchem eine Anzahl Piezo-Elemente flächig aufgebracht ist, wobei an einer Fläche des Piezo-Aktors jeweils ein Piezo-Element vorgesehen ist oder es können an dem Piezo-Aktor übereinander benachbart angeordnete Piezo-Elemente jeweils in Art eines eingespannten Stapels einer Mehrzahl von Piezo-Elementen vorgesehen sein. Vorteilhaft kann hierbei der betreffende Piezo-Bieger parallel zur Wirkrichtung der Aktuatorik vorgespannt sein, um die sich bei der Bewegung ergebende Verkürzung auszugleichen.

In einer bevorzugten Weiterbildung der Energiewandlungsvorrichtung, mit welcher in einem einfachen Aufbau die Vermittlung größerer Drehmomente über größere Kurbellängen gestattet ist, kann die Aktuatorik mit einer Übersetzungsmechanik versehen sein, wobei insbesondere eine Mehrzahl von Piezo-Aktoren jeweils mit mindestens einem Piezo-Element vorgesehen sein kann, die eine gegebenenfalls gelenkig gelagerte Anordnung bilden. Eine weitere vorteilhafte Ausführung kann vorsehen, die Aktuatorik einteilig mit der Koppel, etwa also dem Pleuel, auszubilden, um erhöhte Biegesteifigkeiten zu gewährleisten.

Besonders bevorzugt kann hierbei in einer Weiterbildung die gelenkig gelagerte Anordnung von Piezo-Aktoren eine geradzahlige Anzahl von Aktoren aufweisen, insbesondere mit vier Aktoren versehen sein, und es können wenigstens zwei gegenüberliegende Umlenkpunkte der Anordnung durch ein starres Verbindungsglied verbunden sein. Es sind aber auch andere Anzahlen, auch ungerade Anzahlen denkbar. Das starre Verbindungsglied kann dabei zweckmäßiger Weise durch die als Pleuel ausgebildete Koppel gebildet sein, die mit der Übersetzungsmechanik die Schub-/Kippbewegung ausführt. Auch bei der gelenkig gelagerten Anordnung von Piezo-Aktoren kann eine Hälfte der Aktoren, nämlich die Antagonisten, durch rückstellende Federelemente ersetzt sein. Sind alle Aktoren, also Agonisten und Antagonisten, der gelenkigen Anordnung mit Piezo-Elementen versehen, so lässt sich die Phasenlage der einzelnen Aktoren, analog beispielsweise zu einem mit Piezo-Elementen versehenen Biegebalken, wie folgt beschreiben: gegenüberliegende Piezo-Aktoren (Oberseite zu Unterseite) werden gegenphasig (180°) angesteuert (Agonist - Antagonist), während auf einer "Seite" angeordnete Piezo-Elemente, je nach Drehrichtung, eine Phase von +90° bzw. -90° zueinander haben.

Eine abtriebsseitig gleichförmige und ruckelfreie Bewegung an der Welle lässt sich mit einer Ausführung der Energiewandlungsvorrichtung erreichen, bei der das wenigstens eine Piezo-Element des wenigstens einen Piezo-Aktors der wenigstens einen Aktuatorik, insbesondere alle Piezo-Elemente der Anordnung einzeln oder in Gruppen durch ein regelmäßiges elektrisches Steuersignal, insbesondere ein sinusförmiges, dreiecksförmiges, trapezförmiges oder rechteckförmiges förmiges Steuersignal, ansteuerbar oder angesteuert sind. Um ein Depolarisieren / Umpolen etwa einer Piezo-Keramik zu verhindern, könne Piezo-Aktoren überdies mit einer ausreichenden Offsetspannung beaufschlagt sein, beispielsweise mit einem halben Spannungshub. Eine derart relative Beziehung reduzierte sich bei entsprechend niedrigerem Spannungsbedarf ebenfalls.

Eine Energiewandlungsvorrichtung mit erhöhter Beaufschlagung einer abtriebsseitigen Welle lässt sich erzielen, indem bei einer Weiterbildung eine Mehrzahl von Aktuatoriken vorgesehen und dazu eingerichtet ist, mit dem Rotationsglied in Wirkverbindung zu stehen, insbesondere in einer reihenförmigen oder einer sternförmigen Anordnung.

Hierbei kann, wie bereits erwähnt, die Energiewandlervorrichtung in zweckmäßigen Ausführungen einerseits als Motor, andererseits als Generator betreibbar eingerichtet sein. Damit kann die betreffende Energiewandlungsvorrichtung quasi auch als Sensor für die jeweilige Position des Rotationsglieds angesehen bzw. betrieben werden und damit auch als Winkelmesser und/oder als Drehzahlmesser, da eine sensorlose Positionserkennung möglich ist.

Die obigen Ausgestaltungen und Weiterbildungen lassen sich, sofern sinnvoll, beliebig miteinander kombinieren, etwa zur Erhöhung des Drehmoments durch Parallelschaltung. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird dabei der Fachmann auch Einzelaspekte als Verbesserungen oder Ergänzungen zu der jeweiligen Grundform der vorliegenden Erfindung hinzufügen.

Die Erfindung wird nachstehend anhand von Ausführungsbeispielen in der Zeichnung näher erläutert. In teilweise stark schematisierter Darstellung zeigen hierbei die
- Fig.1: eine ebene Ansicht des bei der Drehmomenterzeugung durch eine erfindungsgemäße Energiewandlungsvorrichtung Kräftegleichgewichts;
- Fig.2, 3: jeweils eine ebene geschnittene Ansicht von als Biegebalken ausgebildeten Aktuatoriken der Energiewandlungsvorrichtung mit an beiden flächigen Seiten des Piezo-Aktors (Fig.2) angeordneten Piezo-Elementen und mit einseitig angeordneten Piezo-Elementen (Fig.3);
- Fig.4, 5: jeweils eine ebene, geschnittene Ansicht von als Biegebalken ausgebildeten Aktuatoriken der Energiewandlungsvorrichtung mit beiderseits des Balkens angeordneten, eingeklemmten Piezo-Stacks (Fig.4) und mit an einer Seite angeordneten Piezo-Stacks und Federn als Rückstellelementen (Fig.5);
- Fig.6, 7: jeweils eine ebene, geschnittene Ansicht einer Aktuatorik mit einer Übersetzungsmechanik, bei welcher eine Mehrzahl von eine gelenkige Anordnung bildenden Piezo-Aktoren jeweils mit einem Piezo-Element versehen ist (Fig.6), während bei der zweiten Darstellung (Fig.7) die rückstellenden Aktoren durch Federelemente ersetzt sind;
- Fig.8: eine Ausführungsbeispiel einer erfindungsgemäßen Energiewandlungsvorrichtung, bei welcher der mittlere Aktuatorabtrieb mit einem Hubzapfen über die Koppel verbunden ist und ein Aktuatorgehäuse mit dem Kurbelgehäuse verbunden ist und ruht;
- Fig.9: eine schematische Darstellung des bei dem Beispiel in der Fig.8 Anwendung findenden Prinzips der Zapfenerweiterung;
- Fig.10: eine Auftragung des elektrischen Ansteuerschemas der Piezo-Aktoren der Aktuatorik der Fig.8;
- Fig.11,12: Bewegungsmoden von Energiewandlungsvorrichtungen mit verschiedenen Aktuatoriken, bei welchen der mittlere Aktuatorabtrieb festgelegt ist, während das jeweilige Aktuatorgehäuse mit dem Hubzapfen verbunden ist wobei die Aktuatorik einmal durch einen Piezo-Bieger gebildet ist (Fig.11) und das andere Mal mit gelenkig gelagerten Piezo-Stacks versehen ist;
- Fig.13: ein weiteres Ausführungsbeispiel der Energiewandlungsvorrichtung mit einer Aktuatorik aus gelenkig gelagerten Piezo-Stacks und mit einem durch ein Planetengetriebe gebildeten Rotationsglied, bei der der mittlere Aktuatorabtrieb mit einem Planetenrad über ein Pleuel der Koppel verbunden (nicht rotierend) ist und der Abtrieb über Zentralrad und/oder Planetenträger stattfindet;
- Fig.14: schematisierte Darstellung des Kurbeltriebs der Fig.13;
- Fig.15: das der Energiewandlungsvorrichtung der Fig.13 und 14 zugeordnete elektrische Ansteuerschema;

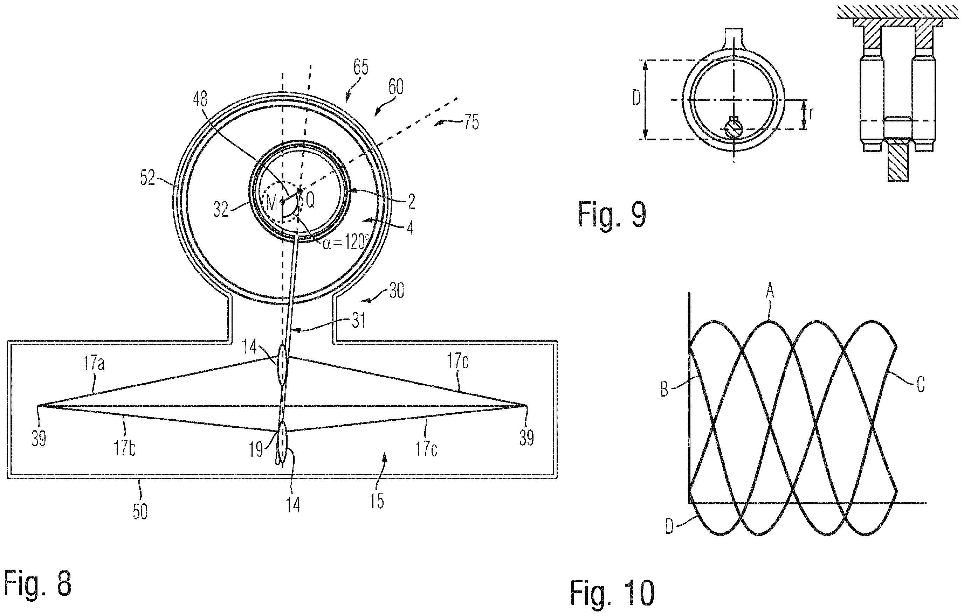

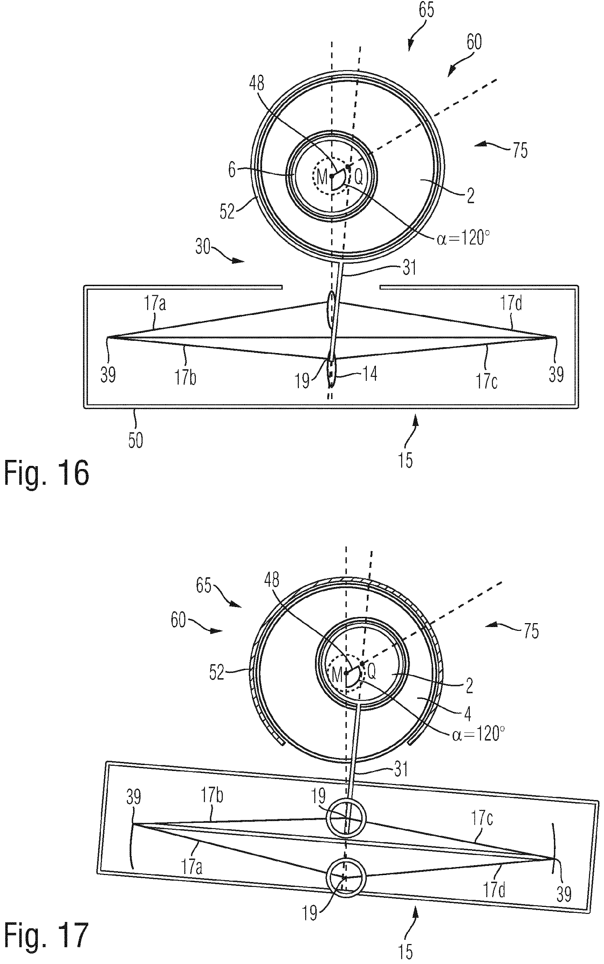

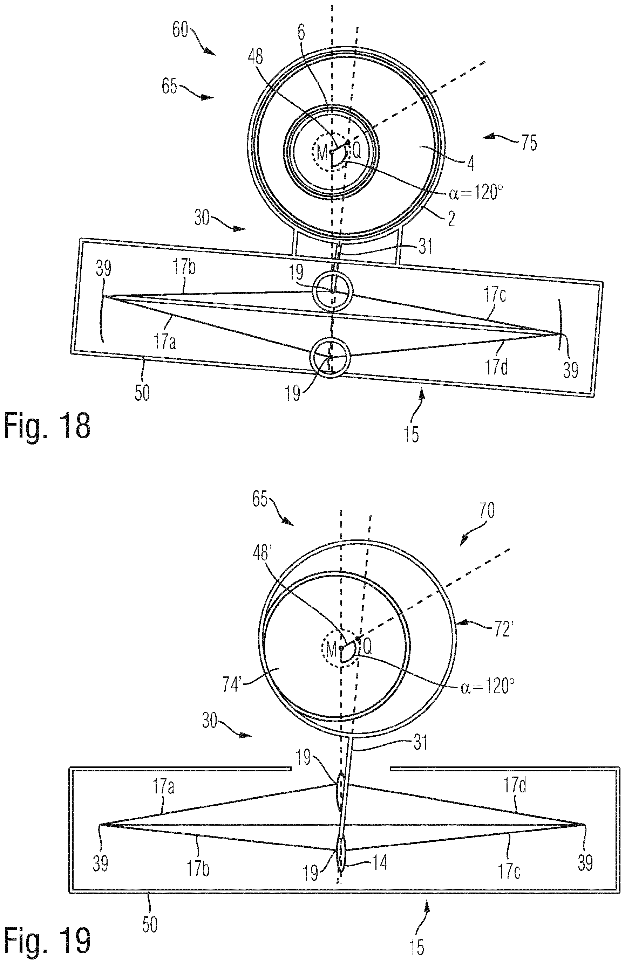

- Fig.16, 17,: 18weitere Konfigurationen von Ausführungsbeispielen einer erfindungsgemäßen Energiewandlungsvorrichtung analog zur Darstellung in der Fig.8, bei welchen zum einen der mittlere Aktuatorabtrieb mit dem Hubzapfen über das Pleuel verbunden ist, während das Aktuatorgehäuse ruhend mit einem Wellenzapfen verbunden ist (Fig.16), zum anderen der mittlere Aktuatorabtrieb ruhend mit dem Kurbelgehäuse verbunden ist, während das Aktuatorgehäuse über das Pleuel mit dem Hubzapfen verbunden ist (Fig.17), des weiteren der mittlere Aktuatorabtrieb ruhend mit dem Hubzapfen verbunden ist, während das Aktuatorgehäuse über das Pleuel mit dem Kurbelgehäuse verbunden ist (Fig.18); und
- Fig.19: ein weiteres Ausführungsbeispiel der Energiewandlungsvorrichtung analog zur Fig. 13, bei welcher jedoch das Planetenrad eine Innenverzahnung und das Zentralrad eine Außenverzahnung aufweist.

In allen Figuren sind gleiche bzw. funktionsgleiche Elemente und Vorrichtungen - sofern nichts Anderes angegeben ist - mit denselben Bezugszeichen versehen worden.

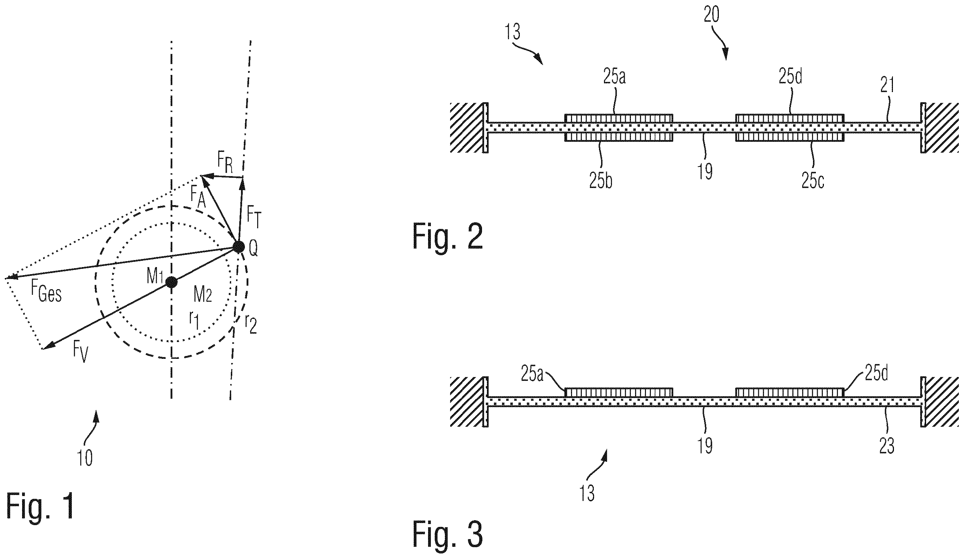

In der Fig.1 erkannt man dabei zunächst eine ebene Ansicht des bei der Drehmomenterzeugung an einer im Ganzen mit 10 bezeichnete, erfindungsgemäße Energiewandlungsvorrichtung 10 auftretenden Kräftegleichgewichts. Dabei sind der Radius r₁ und der Radius r₂ zu erkennen, von denen ersterer den Radius einer von einer Kurbel entkoppelten Pleuelbewegung darstellt, während letzterer den ein er an eine Kurbelbewegung gekoppelten Radius bildet. Der Punkt Q bildet dabei den Mittelpunkt eines Hubzapfens 2 (nicht gezeigt), der auf dem jeweiligen Radius um die hier konzentrischen Mittelpunkte M1, M2 einer Welle 4 (nicht gezeigt) auf einer Kreisbahn mit diesem Radius bewegt wird. Der Radius als Abstand der beiden Punkte M und Q bildet dabei demnach die Kurbellänge. Weiter erkennt man tangential am Radius r₂ die resultierende Aktuatorkraft F_{A}, während F_{R} den Anteil der Kippkraft des Aktuators (radial) bedeutet und _{FT} den Anteil der Schubkraft (transversal). Die durch den im Zwangslauf befindlichen Aktuator verursachte Vorspannkraft drückt sich dabei durch F_{V} aus, während die Gesamtkraft durch F_{Ges} gezeigt wird.

In der Fig.2 und 3 sind einfache Aktuatoriken 13 mit zwei verschiedene Konfigurationen von Piezo-Aktoren 20 als Biegebalken zu erkennen und zwar zunächst in der Fig.2 als ein sogenannter bimorpher Biegebalken 21, der Piezo-Elemente 25a,25b, 25c, 25d zu beiden flächigen Seiten des Piezo-Aktors 20 aufweist, wobei die Piezo-Elemente 25a,25b, 25c, 25d flächig mit dem Piezo-Aktor 20 verklebt sind. Sodann erkennt man in der Fig.3 einen Piezo-Aktor 20 als sogenannten monomorphen Biegebalken 23 mit an nur einer der Flachseiten angeordneten, wiederum verklebten Piezo-Elementen 25a, 25d. In beiden Figuren sind die Biegebalken 21, 23 an ihren Enden eingespannt und bilden als sogenannter Piezo-Bieger selbst bereist eben eine Aktuatorik 13 bzw. ein Aktuator-Element 17.

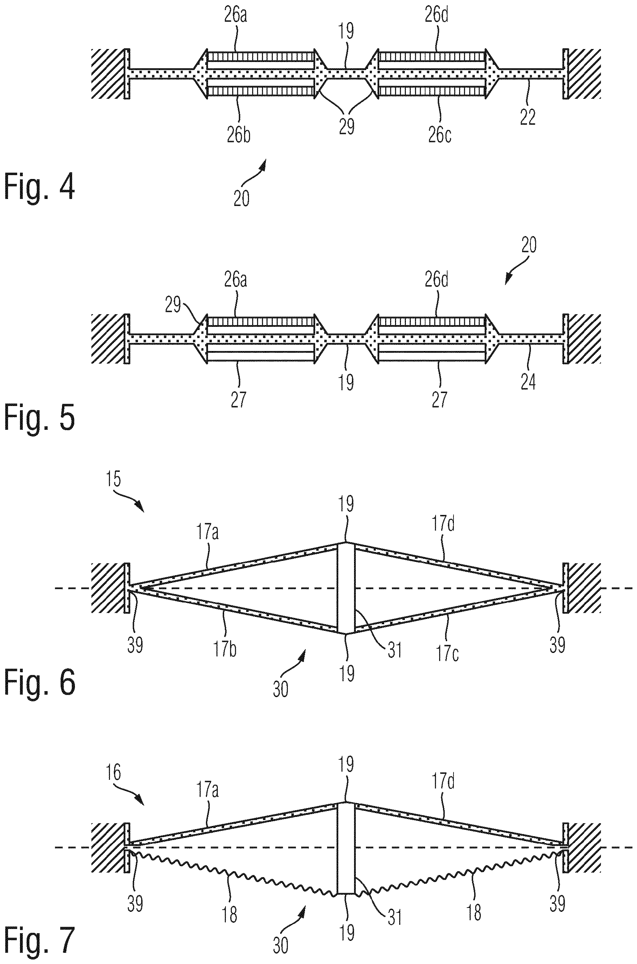

Dies gilt auch für die Biegebalken 22, 24, die in den Fig. 4 und 5 erkennbar sind, die Fig.4 zeigt wiederum zuerst einen bimorphen Biegebalken 22, der Piezo-Elemente 26a, 26b, 26c, 26d zu beiden flächigen Seiten des Piezo-Aktors 20 aufweist, diese sind in Stapel-Form als sogenannte Stacks angeordnet und könne zwischen Klemmelementen 29 eingeklemmt sein, diese bilden die einzigen Stützpunkte der Piezo-Elemente 26a, 26b, 26c, 26d an dem Biegebalken 22. Eine Verklebung ist hier allerdings zusätzlich denkbar. In der Fig.5 erkennt man wiederum einen Piezo-Aktor 20 als sogenannten monomorphen Biegebalken 24 mit an nur einer der Flachseiten angeordneten, gestackten Piezo-Elementen 26a, 26d. In der Fig.5 sind an der "Rückseite" des Piezo-Aktors 20 prinzipiell anordenbare Piezo-Elemente durch Federelemente 27 ersetzt. In beiden Figuren 4 und 5 sind wiederum die Biegebalken 22, 24 an ihren Enden eingespannt.

Bei den Biegebalken 22, 24 der Fig.4 und 5 wird der sogenannte piezoelektrischer Longitudinaleffekt (d₃₃-Effekt) genutzt, bei dem die mechanische Kraft parallel zu einem angelegten Feld wirkt. In longitudinalen Piezoaktoren wird das elektrische Feld, beispielsweise in einer Keramikschicht, also parallel zur Richtung der Polarisation angelegt. Dadurch wird eine Dehnung oder Auslenkung in Richtung der Polarisation induziert. Einzelne Schichten der betreffenden Stacks liefern zwar relativ geringe Auslenkungen. Bei den Stapelaktoren (Stacks) sind jedoch viele Einzellagen mechanisch in Reihe und elektrisch parallel verschaltet sind. Die Wandlungseffizienz elektrischer in mechanische Energie ist für longitudinale Stapelaktoren hoch so dass Nominalauslenkungen in der Größenordnung einiger Zehntelprozent der Aktorlänge erzielt werden können. Solche longitudinale Stapelaktoren eignen sich gut für den hochdynamischen Betrieb, da sie hohe Resonanzfrequenzen aufweisen. Gegebenenfalls auftretende dynamische (Zug-)Kräfte bei sprödem Material (etwa einer Keramik) können durch eine mechanische Vorspannung kompensiert werden, wodurch sehr kurze Ansprechzeiten im Mikrosekundenbereich und hohe mechanische Leistungen erzielt werden können.

Demgegenüber wird bei den Biegebalken 21, 23 der Piezo-Aktoren 20 aus den Fig. 3 und 4 mit ihren einschichtigen Piezo-Elementen 25a-25d neben dem longitudinalen auch der piezoelektrischer Transversaleffekt (d₃₁-Effekt) genutzt, bei dem die mechanische Kraft quer zum angelegten Feld wirkt. Solche piezoelektrischen Biegeaktoren funktionieren nach dem Prinzip von Thermobimetallen. Durch seine Ansteuerung kontrahiert der Piezo-Aktor 20 und verursacht ein Biegemoment, das die geringe transversale Längenänderung in eine große Biegeauslenkung senkrecht zur Kontraktion umwandelt. Je nach Geometrie sind Übersetzungsfaktoren in zweistelliger Größenordnung, jedoch mit geringerer Wandlungseffizienz und Kraft, erreichbar. Gestapelte (gestackte) Mehrschichtelemente bieten gegenüber einschichtigen Piezoelementen bei der technische Realisierung Vorteile, da sie aufgrund ihrer größeren Querschnittsfläche höhere Kräfte erzeugen bzw. umgekehrt mit niedrigerer Ansteuerspannung betrieben werden können.

In den Fig.6 und 7 sind Übersetzungsmechaniken für Aktuatoriken 15, 16 zu erkennen, die die Verwendung größerer (dem Radius r₂ aus der Fig.1 entsprechenden) Kurbellängen 48 gestattet, wodurch sich trotz einfachen Aufbaus das übertragbare Drehmoment vergrößern lässt. Die Fig.6 zeigt dabei eine gelenkige Aktuatorik 15, die mit vier jeweils durch Piezo-Aktoren 20, beispielsweise mit Aktoren 20 aus den Fig.4 und 5, gebildete Aktuator-Elemente 17a-17d, die eine in etwa rautenförmige Anordnung bilden. An den für den Betrachter linken und rechten spitzen Enden der Anordnung 15 ist diese am Treffpunkt der Aktuator-Elemente 17a und 17b sowie 17 d und 17c gelenkig gelagert, während zwischen den Treffpunkten der Aktuator-Elemente 17a und 17 d sowie 17b und 17c eine starre Verbindung besteht, die durch einen Abschnitt des in dieser Figur nicht näher dargestellten Pleuels 31 der Koppel 30 gebildet ist. Die Fig.7 stellt einen im Wesentlichen ähnlichen Sachverhalt dar, hier sind jedoch die Aktuator-Elemente 17b und 17 c durch FederElemente 18 ersetzt, die ein ansonsten durch Piezo-Aktoren 20 von Aktuator-Elementen 17a-d aufzubringende Rückstellkraft liefern.

In beiden Fig. 6 und 7 erkennt man Anlenkpunkte 19, die durch den Abschnitt des Pleuels 31 miteinander verbunden sind, an denen aber gleichwohl Aktuator-Elemente 17- und 17 d sowie 17b und 17c gelenkig verbunden sind, sowie Gelenkpunkte 39, an welchen die Aktuatoriken gelenkig aufgehängt sind. Die betreffenden Gelenkpunkte 39 können etwa als Festköpergelenke, als gegeneinander abrollende Schalenelemente oder anderweitig ausgebildetes Gelenkglied ausgebildet sein.

Eine Aktuatorik 15, wie sie in der Fig. 6 gezeigt wurde, bildet für die in der Fig.8 erkennbare, im Ganzen mit 10 bezeichnete Energiewandlungsvorrichtung die Schub-/Kipp-Aktuatorik, die an dem Pleuel 31 als Koppel 30 die kombinierte Schub- / Kippbewegung erzeugt, welche wiederum an den Bewegungsellipsen 14 erkennbar ist, die die Anlenkpunkte 19 an den Treffpunkten der Aktuator-Elemente 17a und 17d sowie 17b und 17c mit der kombinierten Schub-/Kippbewegung ausführen. Diese kombinierten Schub-/Kippbewegung überträgt das Pleuel 31 mit seinem an seinem freien Ende angeordneten Auge 32 an einen Hubzapfen 2, der durch das Auge 32 greift und eine Zapfenerweiterung 75 der Welle 4 bildet. Hierdurch ist der mittlere Aktuatorabtrieb mit dem Hubzapfen 2 über das Pleuel 31 verbunden, während das Aktuatorgehäuse 50 mit dem Kurbelgehäuse 52 verbunden ist und beide ruhen. Gezeigt ist das Pleuel 31 in der Fig.8 bei einem Rotationswinkel α des Kurbeltriebs 60 als Rotationsglied 65 von 120°, weiter erkennt man erneut den Abstand zwischen der Mittelachse des Hubzapfens 2 und der Welle 4 als die Kurbellänge 48, die in der zur Veranschaulichung gezeigten Fig.9 den als Abstand r dargestellt ist. In der Fig.10 ist zur Verdeutlichung der Ansteuerung der Piezo-Aktoren 20 der Aktuator-Elemente 17a-d ein sinusförmiges elektrisches Ansteuerschema dargestellt, wobei der Buchstabenindex A, B, C, D der jeweiligen Kurve der Indizierung des Aktuator-Elements 17a-d entspricht.

In zu der Darstellung der Fig.8 ähnlicher Weise sind weitere Konfigurationen mit einer Zapfenerweiterung 75 als Kurbelprinzip des Kurbeltriebs möglich und denkbar. So kann in einer weiteren Konfiguration in der Fig. 16 der mittlere Aktuatorabtrieb mit dem Hubzapfen 2 über das Pleuel 31 verbunden sein, während das Aktuatorgehäuse 50 ruhend mit einem Wellenzapfen 6 verbunden ist. In einer weiteren Konfiguration, wie sie in der Fig.17 gezeigt ist, kann der mittlere Aktuatorabtrieb ruhend mit dem Kurbelgehäuse 52 verbunden sein, während das Aktuatorgehäuse 50 über das Pleuel 31 mit dem Hubzapfen 2 verbunden ist, hierbei sind die Anlenkpunkte 19 also ruhend, während sich die Gelenkpunkte 39 der Aktuatorik 15 quasi-elliptisch bewegen. In einer weiteren Konfiguration in der Fig.18 kann der mittlere Aktuatorabtrieb ruhend mit dem Hubzapfen 2 verbunden sein, während das Aktuatorgehäuse 50 über das Pleuel 31 mit dem Kurbelgehäuse verbunden ist, wodurch für Anlenk- und Gelenkpunkte 19, 39 das Gleiche gilt wie eben zuvor.

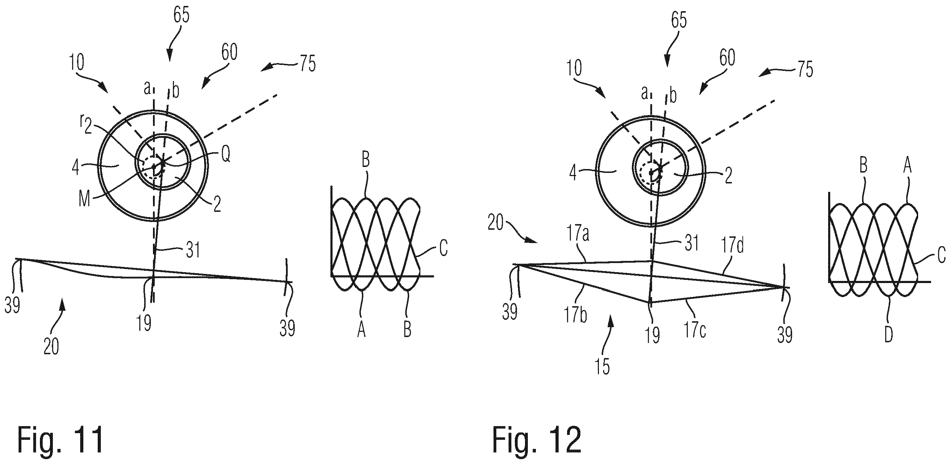

Hierzu zeigen die Darstellungen der Fig.11 und 12 eine Konfiguration der Energiewandlungsvorrichtung 10, bei der der mittlere Aktuator-Abtrieb festgelegt ist, die Anlenkpunkte 19 also fest sind, während das jeweilige Aktuatorgehäuse 50 (nicht gezeigt) mit dem Hubzapfen 2 verbunden ist. Dies führt dazu, dass die Gelenkpunkte 39 sich in auf etwa elliptischen Pfaden, verursacht durch die Schub-/ Kippaktuatorik, bewegen. Der Unterschied zwischen den Darstellungen der Fig.11 und 12 besteht in den unterschiedlichen Aktuatoriken 13, 15 mit ihren Piezo-Aktoren 20 bzw. ihren Aktuator-Elementen 17a-17d. In der Fig.11 ist die Aktuatorik 13 durch einen einzelnen als Piezobieger ausgebildeten Piezo-Aktor 20 realisiert, während die Aktuatorik 15 der Fig.12 erneut eine gelenkige Anordnung von Piezo-Aktoren 20 in Stapelbauweise zeigt, die mit Aktuator-Elemente 17a-17d versehen ist. Beide Figuren zeigen Aktuatoriken 13, 15 mit einem Kurbeltrieb 60 als Rotationsglied 65 bei einem Rotationswinkel α von 120°. Zu erkennen sind in den Figuren erneut die Auftragungen der zu den einzelnen Aktoren gehörenden elektrischen Ansteuersignale, deren Indizierung derjenigen des Biegers als Piezo-Aktor 20 aus der Fig. 2 für die Piezoelemente 25a-25d bzw. derjenigen der Aktuator-Elemente 17a-17d aus der Fig.6 entspricht.

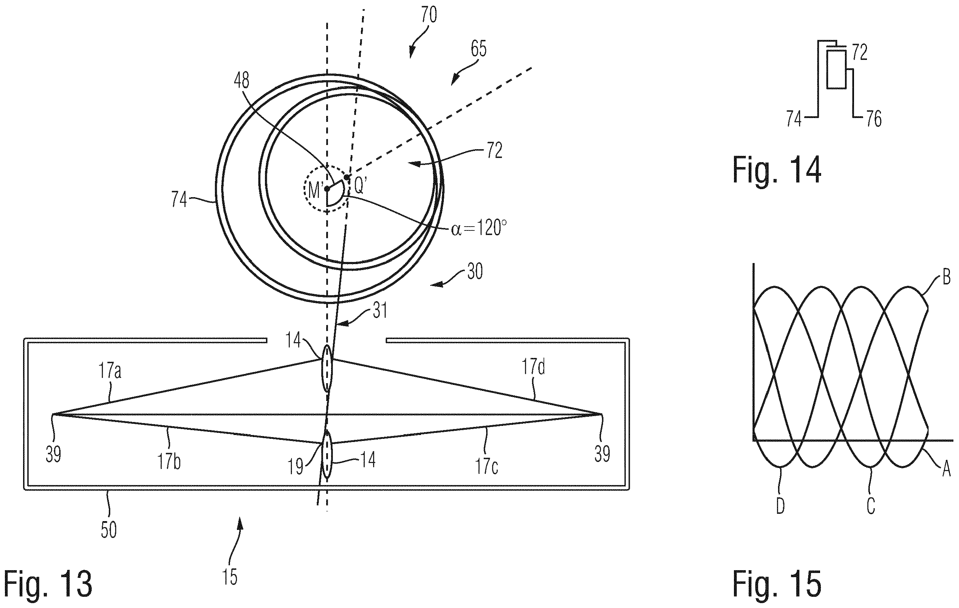

Auch in der Fig. 13 erkennt man den dortigen Kurbeltrieb 60 mit einem Rotationswinkel α von 120°. Im Unterschied zu den bisherigen Kurbeltrieben 60 mit einer Zapfenerweiterung 75 mit Hubzapfen 2 ist in der Fig.13 eine Energiewandlungsvorrichtung 10 mit einem Rotationstrieb 65 mit Planetengetriebe 70 gezeigt. Der mittlere Aktuatorabtrieb ist mit einem Planetenrad 72 über das Pleuel 31 nicht rotierend verbunden, während der Abtrieb über ein Zentralrad 74 und/oder (nicht gezeigte) Planetenträger 76 stattfindet. Der Planetenträger 76 übernimmt hier die Funktion des Zwangslaufs. Dabei hat man ein innenverzahntes Zentralrad 74, das mit einem außenverzahnten Planetenrad 72 in Eingriff steht und kämmt, was schematisch nochmals die Fig. 14 zeigt. Der Abstand des Mittelpunkts Q' des Planetenrads 72 und des Mittelpunkts M' des Zentralrads 74 bildet hierbei die Kurbellänge 48' des Planetenträgers 76. Die Aktuatorik 15 entspricht derjenigen aus der Fig.8 mit den Aktuator-Elementen 17a-17d und Anlenkpunkten 19, die die Bewegungsellipsen 14 beschreiben. Ebenso wie zuvor entspricht die Referenzierung der dargestellten elektrischen Ansteuersignale in der Fig.15 wiederum derjenigen der Aktuator-Elemente 17a-17d aus der Fig.13.

In analoger Weise zu der Darstellung in den Fig.13 bis 15 lässt sich in einer weiteren Konfiguration, wie sie der Fig.19 zu entnehmen ist, erneut eine Energiewandlungsvorrichtung 10 mit einem Rotationstrieb 65 mit Planetengetriebe 70 zeigen, bei welcher der mittlere Aktuatorabtrieb mit einem Planetenrad 72 über das Pleuel 31 nicht rotierend verbunden, während der Abtrieb über ein Zentralrad 74 und/oder (nicht gezeigte) Planetenträger 76 stattfindet. In dieser Konfiguration ist allerdings die Verzahnung umgekehrt, so das hier ein Zentralrad 74' mit Außenverzahnung und ein Planetenrad 72' mit Innenverzahnung zum Einsatz kommt.

Demnach betrifft die vorstehend beschriebene Erfindung also eine Vorrichtung 10 zur elektromechanischen Energiewandlung zwischen einer Antriebsseite und einer Abtriebsseite der Vorrichtung 10, mit einem Rotationstrieb, mittels dessen eine rotatorische Bewegung eines Rotationsglieds 65 in eine überlagerte Linear- und Kippbewegung einer Koppel 30 umsetzbar ist, mit deren Bereich eines ersten Endes das Rotationsglied 65 verbindbar oder verbunden ist, und mit wenigstens einer Aktuatorik 13, 15, 16, 20 welche mit einem Bereich eines zweiten Endes der Koppel 30 verbindbar oder verbunden ist und welche die überlagerte Linear- und Kippbewegung der Koppel 30 antreibt oder durch diese angetrieben ist.

Um eine Energiewandlungsvorrichtung 10 zur Verfügung zu haben, die einen einfachen, kompakten Aufbau aufweist, geringe Kosten in der Herstellung verursacht, zuverlässig im Betrieb ist und eine verlängerte Lebensdauer mitbringt, ist die wenigstens eine Aktuatorik 13, 15, 16, 20 mit zumindest einem Aktuatorelement 17, 17a-17d versehen, und eine Deformation an dem zumindest einen AktuatorElement 17, 17a-17d der Aktuatorik 13, 15, 16, 20 verursacht die Energiewandlung oder ist durch diese verursacht, und die Aktuatorik 13, 15, 16, 20 bildet einen Schub-/Kipp-Aktuator.

Tatsächlich erkennt man bei der vorliegenden Erfindung auch, dass ein Gehäuse oder eine irgendwie geartete Abstützung vorhanden ist, welche in der Lage ist, Gegenkräfte und Gegenmomente aufzunehmen und es je nach Anwendungsfall gleichwertig ist, entweder das Gehäuse ruhen zu lassen und die Kurbel wie zuvor beschrieben zu betreiben oder aber die Kurbel ruhen zu lassen und anstatt dessen das Gehäuse zu bewegen.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

### Bezugszeichenliste

- 2: Hubzapfen
- 4: (Kurbel-)Welle
- 6: Wellenzapfen
- 10: Energiewandlungsvorrichtung
- 13: Aktuatorik
- 14: Bewegungsellipse
- 15: Aktuatorik
- 16: Aktuatorik
- 17, 17a-d: Aktuator-Element
- 18: Feder-Element
- 19: Anlenkpunkt
- 20: Piezo-Aktor / Aktuatorik
- 21: Biegebalken
- 22: Biegebalken
- 23: Biegebalken
- 24: Biegebalken
- 25a-d: Piezo-Element
- 26a-d: Piezo-Element
- 27: Federelement
- 29: Klemmelement
- 30: Koppel
- 31: Pleuel
- 32: Pleuelauge
- 39: Gelenkpunkte
- 48, 48': Kurbellänge
- 50: Aktuatorgehäuse
- 52: Kurbelgehäuse
- 60: Kurbeltrieb
- 65: Rotationsglied
- 70: Planetengetriebe
- 72, 72': Planetenrad
- 74, 74': Zentralrad
- 75: Zapfenerweiterung
- 76: Planetenträger
- A,B,C,D: elektrische Ansteuersignale
- F_{X}: verschiedene Kräfte F
- α: Rotationswinkel
- r: Radius
- M, M1, M2, M': Mittelpunkt Welle / Zentralrad
- Q, Q': Mittelpunkt Hubzapfen / Planetenrad

## Patentansprüche

1. Vorrichtung zur elektromechanischen Energiewandlung zwischen einer Antriebsseite und einer Abtriebsseite der Vorrichtung, mit einem Rotationstrieb, mittels dessen eine rotatorische Bewegung eines Rotationsglieds (65) in eine überlagerte Linear- und Kippbewegung einer Koppel (30) umsetzbar ist, mit deren Bereich eines ersten Endes das Rotationsglied (65) verbindbar oder verbunden ist, und mit wenigstens einer Aktuatorik (13, 15, 16, 20), welche mit einem Bereich eines zweiten Endes der Koppel (30) verbindbar oder verbunden ist und welche die überlagerte Linear- und Kippbewegung der Koppel (30) antreibt oder durch diese angetrieben ist, wobei die wenigstens eine Aktuatorik (13, 15, 16, 20) mit zumindest einem Aktuator-Element (17, 17a-17d) versehen ist, und eine Deformation an dem zumindest einen Aktuator-Element (17, 17a-17d) der Aktuatorik (13, 15, 16, 20) die Energiewandlung verursacht oder durch diese verursacht ist, **dadurch gekennzeichnet, dass** die Aktuatorik (13, 15, 16, 20) wenigstens einen Schub-/Kipp-Aktuator bildet.

2. Vorrichtung nach Anspruch 1, wobei der Schub-/Kipp-Aktuator durch einen kombinierten Aktuator gebildet ist.

3. Vorrichtung nach Anspruch 1 oder 2, wobei das Rotationsglied (65) mit wenigstens einem Kurbeltrieb (60) oder wenigstens einem Planetengetriebe (70) ausgebildet ist.

4. Vorrichtung nach einem der vorhergehenden Ansprüche, wobei der als Rotationsglied (65) ausgebildete wenigstens eine Kurbeltrieb (60) eine Kurbelwelle (4) über wenigstens eine Zapfenerweiterung (75) mit dem Bereich des ersten Endes der Koppel (30) verbindet.

5. Vorrichtung nach einem der vorhergehenden Ansprüche, wobei das wenigstens eine Planetengetriebe (70) als Rotationsglied (65) mit wenigstens einem Planetenrad (72, 72') versehen ist, welches mit dem Bereich des ersten Endes des Koppel (30) verbindbar oder verbunden ist, wobei das wenigstens eine Planetenrad (72, 72') mit einem Zentralrad (74, 74') in Eingriff steht.

6. Vorrichtung nach Anspruch 4, wobei das Zentralrad (74, 74') mit einer Innenverzahnung oder einer Außenverzahnung zu dem wenigstens einen Planetenrad (72, 72') jeweils komplementär verzahnt ist.

7. Vorrichtung nach einem der vorhergehenden Ansprüche, wobei die Koppel (30) durch eine Art Schubstange oder Treibstange, insbesondere durch ein Pleuel (31) gebildet ist.

8. Vorrichtung nach einem der vorhergehenden Ansprüche, wobei das zumindest eine Aktuator-Element (17, 17a-17d) der Aktuatorik (13, 15, 16) als wenigstens ein Piezo-Aktor (20) oder als wenigstens ein magnetostriktiver Aktor eingerichtet ist.

9. Vorrichtung nach Anspruch 7, wobei der wenigstens eine Piezo-Aktor (20) mit mindestens einem Piezo-Element (25a-25d, 26a-26d), bevorzugt mit einer Mehrzahl von Piezo-Elementen (25a-25d, 26a-26d), vorgesehen ist.

10. Vorrichtung nach Anspruch 7 oder 8, wobei der wenigstens eine Piezo-Aktor (20) mit wenigstens einem Rückstellelement ausgebildet ist, welches bevorzugt durch wiederum wenigstens ein Piezo-Element (25a-25d, 26a-26d) oder durch zumindest ein Federelement (27) gebildet ist.

11. Vorrichtung nach einem der Ansprüche 7 bis 9, wobei der Piezo-Aktor (20) nach Art eines Biegebalkens vorgesehen ist, an welchem eine Anzahl Piezo-Elemente (25a-25d, 26a-26d) flächig aufgebracht ist, wobei an einer Fläche des Piezo-Aktors (20) jeweils ein Piezo-Element (25a-25d) vorgesehen ist oder an dem Piezo-Aktor (20) übereinander benachbart angeordnete Piezo-Elemente (26a-26d)jeweils in Art eines eingespannte Stapels von einer Mehrzahl von Piezo-Elementen (25, 26) vorgesehen sind.

12. Vorrichtung nach einer der vorhergehenden Ansprüche, wobei die Aktuatorik (13, 15, 16, 20) mit einer Übersetzungsmechanik versehen ist, wobei insbesondere eine Mehrzahl von Piezo-Aktoren (20) jeweils mit mindestens einem Piezo-Element (26a-25d, 26a-26d) vorgesehen ist, die eine gegebenenfalls gelenkig gelagerte Anordnung bilden und/oder die Aktuatorik (13, 15, 16, 20) einteilig mit der Koppel (30) ausgebildet ist.

13. Vorrichtung nach Anspruch 11, wobei die gelenkig gelagerte Anordnung von Piezo-Aktoren eine geradzahlige Anzahl von Aktoren (20) aufweist, insbesondere mit vier Aktoren (20) versehen ist, und wenigstens zwei gegenüberliegende Umlenkpunkte (19) der Anordnung durch ein starres Verbindungsglied verbunden sind und/oder das wenigstens eine Piezo-Element (26a-25d, 26a-26d) des wenigstens einen Piezo-Aktors (20) der wenigstens einen Aktuatorik (13, 15, 16, 20), insbesondere alle Piezo-Elemente (26a-25d, 26a-26d) der Aktuatorik einzeln oder in Gruppen durch ein regelmäßiges elektrisches Steuersignal, insbesondere ein sinusförmiges, dreiecksförmiges oder trapezförmiges Steuersignal, ansteuerbar oder angesteuert sind.

14. Vorrichtung nach einem der vorhergehenden Ansprüche, wobei eine Mehrzahl von Aktuatoriken (13, 15, 16, 20) vorgesehen und dazu eingerichtet ist, mit dem Rotationsglied (65) in Wirkverbindung zu stehen, insbesondere in einer reihenförmigen oder einer sternförmigen Anordnung.

15. Vorrichtung nach einem der vorhergehenden Ansprüche, wobei die Vorrichtung als Motor oder als Generator betreibbar ist.

## Claims

1. Apparatus for electromechanical energy conversion between a drive side and an output side of the apparatus, comprising a rotation mechanism by means of which a rotational movement of a rotation member (65) can be converted into a superimposed linear and tilting movement of a coupler (30), the rotation member (65) being connectable or connected to the region of a first end of the said coupler, and comprising at least one actuator system (13, 15, 16, 20) which is connectable or connected to a region of a second end of the coupler (30) and which drives the superimposed linear and tilting movement of the coupler (30) or is driven by this movement, wherein the at least one actuator system (13, 15, 16, 20) is provided with at least one actuator element (17, 17a-17d), and a deformation at the at least one actuator element (17, 17a-17d) of the actuator system (13, 15, 16, 20) causes the energy conversion or is caused by this energy conversion, **characterized in that** the actuator system (13, 15, 16, 20) forms at least one push/tilt actuator.

2. Apparatus according to Claim 1, wherein the push/tilt actuator is formed by a combined actuator.

3. Apparatus according to Claim 1 or 2, wherein the rotation member (65) is designed with at least one crank drive (60) or at least one planetary gear mechanism (70).

4. Apparatus according to one of the preceding claims, wherein the at least one crank drive (60) which is designed as rotation member (65) connects a crank shaft (4) to the region of the first end of the coupler (30) by means of at least one pin extension (75).

5. Apparatus according to one of the preceding claims, wherein the at least one planetary gear mechanism (70) as rotation member (65) is provided with at least one planetary gear (72, 72') which is connectable or connected to the region of the first end of the coupler (30), wherein the at least one planetary gear (72, 72') engages with a central gear (74, 74').

6. Apparatus according to Claim 4, wherein the central gear (74, 74') is toothed with an internal toothing or an external toothing in relation to the at least one planetary gear (72, 72') in a complementary manner in each case.

7. Apparatus according to one of the preceding claims, wherein the coupler (30) is formed by a kind of push rod or drive rod, in particular by a connecting rod (31).

8. Apparatus according to one of the preceding claims, wherein the at least one actuator element (17, 17a-17d) of the actuator system (13, 15, 16) is designed as at least one piezo actuator (20) or as at least one magnetostrictive actuator.

9. Apparatus according to Claim 7, wherein the at least one piezo actuator (20) is provided with at least one piezo element (25a-25d, 26a-26d), preferably with a plurality of piezo elements (25a-25d, 26a-26d).

10. Apparatus according to Claim 7 or 8, wherein the at least one piezo actuator (20) is designed with at least one return element which is preferably formed by, once again, at least one piezo element (25a-25d, 26a-26d) or by at least one spring element (27).

11. Apparatus according to one of Claims 7 to 9, wherein the piezo actuator (20) is provided in the form of a bending bar to the surface of which a number of piezo elements (25a-25d, 26a-26d) are applied, wherein in each case one piezo element (25a-25d) is provided on a surface of the piezo actuator (20) or piezo elements (26a-26d) which are arranged in an adjacent manner one above the other are provided on the piezo actuator (20) in each case in the manner of a clamped-in stack of a plurality of piezo elements (25, 26).

12. Apparatus according to one of the preceding claims, wherein the actuator system (13, 15, 16, 20) is provided with a transmission mechanism, wherein in particular a plurality of piezo actuators (20) is in each case provided with at least one piezo element (26a-25d, 26a-26d), which piezo actuators form an arrangement which may be mounted in an articulated manner, and/or the actuator system (13, 15, 16, 20) is integrally formed with the coupler (30).

13. Apparatus according to Claim 11, wherein the arrangement of piezo actuators, which arrangement is mounted in an articulated manner, has an even number of actuators (20), in particular is provided with four actuators (20), and at least two opposite deflection points (19) of the arrangement are connected by a rigid connecting element and/or the at least one piezo element (26a-25d, 26a-26d) of the at least one piezo actuator (20) of the at least one actuator system (13, 15, 16, 20), in particular all of the piezo elements (26a-25d, 26a-26d) of the actuator system, is/are actuable or actuated individually or in groups by a regular electrical control signal, in particular a sinusoidal, triangular or trapezoidal control signal.

14. Apparatus according to one of the preceding claims, wherein a plurality of actuator systems (13, 15, 16, 20) are provided and designed to be operatively connected to the rotation member (65), in particular in a series or a star arrangement.

15. Apparatus according to one of the preceding claims, wherein the apparatus can be operated as a motor or as a generator.

## Revendications

1. Dispositif de conversion d'énergie électromécanique entre un côté menant et un côté mené du dispositif, comprenant un mécanisme de rotation au moyen duquel un mouvement de rotation d'un élément rotatif (65) peut être converti en un mouvement superposé linéaire et de basculement d'une barre de liaison (30) avec la zone d'une première extrémité de laquelle peut être relié ou est relié l'élément rotatif (65), et comprenant au moins un système actionneur (13, 15, 16, 20) qui peut être relié ou qui est relié à une zone d'une deuxième extrémité de la barre de liaison (30) et qui entraîne le mouvement superposé linéaire et de basculement de la barre de liaison (30) ou est entraîné par celui-ci, l'au moins un système actionneur (13, 15, 16, 20) étant pourvu d'au moins un élément actionneur (17, 17a-17d) et une déformation au niveau de l'au moins un élément actionneur (17, 17a-17d) du système actionneur (13, 15, 16, 20) causant la conversion d'énergie ou étant causée par celle-ci, **caractérisé en ce que**
le système actionneur (13, 15, 16, 20) forme au moins un actionneur de poussée/basculement.

2. Dispositif selon la revendication 1, l'actionneur de poussée/basculement étant formé par un actionneur combiné.

3. Dispositif selon la revendication 1 ou 2, l'élément rotatif (65) étant formé avec au moins un mécanisme à manivelle (60) ou au moins un engrenage planétaire (70).

4. Dispositif selon l'une des revendications précédentes, l'au moins un mécanisme à manivelle (60) réalisé sous la forme d'un élément rotatif (65) reliant un vilebrequin (4) à la zone de la première extrémité de la barre de liaison (30) par le biais d'au moins une extension à tenon (75).

5. Dispositif selon l'une des revendications précédentes, l'au moins un engrenage planétaire (70) étant pourvu en tant qu'élément rotatif (65) d'au moins un pignon planétaire (72, 72') qui peut être relié ou est relié à la zone de la première extrémité de la barre de liaison (30), l'au moins un pignon planétaire (72, 72') étant engrené avec un pignon central (74, 74').

6. Dispositif selon la revendication 4, le pignon central (74, 74') étant denté avec une denture interne ou une denture externe de façon à chaque fois complémentaire par rapport à l'au moins un pignon planétaire (72, 72').

7. Dispositif selon l'une des revendications précédentes, la barre de liaison (30) étant formée par un type de barre de poussée ou de barre de manoeuvre, notamment par une bielle (31).

8. Dispositif selon l'une des revendications précédentes, l'au moins un élément actionneur (17, 17a-17d) du système actionneur (13, 15, 16) étant conçu sous la forme d'au moins un actionneur piézoélectrique (20) ou sous la forme d'au moins un actionneur magnétostrictif.

9. Dispositif selon la revendication 7, l'au moins un actionneur piézoélectrique (20) étant pourvu d'au moins un élément piézoélectrique (25a-25d, 26a-26d), de préférence d'une pluralité d'éléments piézoélectriques (25a-25d, 26a-26d).

10. Dispositif selon la revendication 7 ou 8, l'au moins un actionneur piézoélectrique (20) étant réalisé avec au moins un élément de rappel qui est de préférence formé à son tour par au moins un élément piézoélectrique (25a-25d, 26a-26d) ou par au moins un élément ressort (27).

11. Dispositif selon l'une des revendications 7 à 9, l'actionneur piézoélectrique (20) étant conçu sous la forme d'une poutrelle flexible sur laquelle sont montés un certain nombre d'éléments piézoélectriques (25a-25d, 26a-26d), un élément piézoélectrique (25a-25d) se trouvant respectivement sur une surface de l'actionneur piézoélectrique (20) ou des éléments piézoélectriques (26a-26d) disposés adjacents les uns au-dessus des autres se trouvant respectivement sur l'actionneur piézoélectrique (20) à la manière d'un empilement attelé d'une pluralité d'éléments piézoélectriques (25, 26).

12. Dispositif selon l'une des revendications précédentes, le système actionneur (13, 15, 16, 20) étant pourvu d'un mécanisme de démultiplication, une pluralité d'actionneurs piézoélectriques (20) respectivement munis d'au moins un élément piézoélectrique (26a-25d, 26a-26d) étant notamment présents, lesquels forment un arrangement supporté éventuellement de manière articulée et/ou le système actionneur (13, 15, 16, 20) est réalisé d'un seul tenant avec la barre de liaison (30).

13. Dispositif selon la revendication 11, l'arrangement supporté de manière articulée de actionneurs piézoélectriques possédant un nombre pair d'actionneurs (20), étant notamment pourvu de quatre actionneurs (20), et au moins deux points de renvoi (19) opposés de l'arrangement étant reliés par un élément de liaison rigide et/ou l'au moins un élément piézoélectrique (26a-25d, 26a-26d) de l'au moins un actionneur piézoélectrique (20) de l'au moins un système actionneur (13, 15, 16, 20), notamment tous les éléments piézoélectriques (26a-25d, 26a-26d) du système actionneur, pouvant être commandés ou étant commandés par un signal de commande électrique régulier, notamment un signal de commande sinusoïdal, triangulaire ou trapézoïdal.

14. Dispositif selon l'une des revendications précédentes, une pluralité de systèmes actionneurs (13, 15, 16, 20) étant présents et conçus pour se trouver en liaison fonctionnelle avec l'élément rotatif (65), notamment dans un arrangement en forme de rangée ou en forme d'étoile.

15. Dispositif selon l'une des revendications précédentes, le dispositif pouvant être utilisé en tant que moteur ou en tant que générateur.
